# EUROPEAN PATENT SPECIFICATION

(11) **EP 2 185 974 B1**
(45) Date of publication and mention of the grant of the patent: **18.04.2012**
(21) Application number: 08792316.5
(22) Date of filing: 01.08.2008
(51) Int. Cl.: B82Y 10/00, G03F 7/00

(54) **IMPRINT METHOD AND PROCESSING METHOD OF SUBSTRATE**
PRÄGEVERFAHREN UND VERFAHREN ZUR VERARBEITUNG EINES SUBSTRATS
PROCÉDÉ D'EMPREINTE ET PROCÉDÉ DE TRAITEMENT DE SUBSTRAT

(30) Priority: 03.08.2007 JP 2007203044; 14.07.2008 JP 2008182301
(43) Date of publication of application: 19.05.2010
(73) Proprietor: Canon Kabushiki Kaisha, Tokyo 146-8501 (JP)
(72) Inventor: OKUSHIMA, Shingo, Tokyo 146-8501 (JP); SEKI, Junichi, Tokyo 146-8501 (JP); ONO, Haruhito, Tokyo 146-8501 (JP); NAKATSUJI, Nao, Tokyo 146-8501 (JP)
(74) Representative: TBK
(86) International application number: PCT/JP2008/064259
(87) International publication number: WO 2009/020193

(56) References cited:
- EP-A- 1 762 893
- EP-A- 1 801 649
- US-A1- 2004 008 334
- US-A1- 2006 019 027
- US-A1- 2006 266 916
- JEONG ET AL: "A step-and-repeat UV-nanoimprint lithography process using an elementwise patterned stamp" MICROELECTRONIC ENGINEERING, ELSEVIER PUBLISHERS BV., AMSTERDAM, NL, vol. 82, no. 2, 1 October 2005 (2005-10-01), pages 180-188, XP005091207 ISSN: 0167-9317

## Description

### [TECHNICAL FIELD]

The present invention relates to an imprint method for imprinting a pattern of a mold onto a resin material layer and a processing method of a substrate.

### [BACKGROUND ART]

In recent years, a fine processing technology for transferring a fine structure on a mold onto a member to be processed such as a resin material, a metal material, or the like has been developed and has received attention (Stephan Y. Chou et al., Appl. Phys. Lett., Vol., 67, Issue 21, pp. 3114 - 3116 (1995)). This technology is called nanoimprint or nanoembossing and provides a resolution on the order of several nanometers. For this reason, the technology has been increasingly expected to be applied to next-generation semiconductor manufacturing technologies in place of light exposure devices such as a stepper, a scanner, and the like. Further, the technology is capable of collectively processing a three-dimensional structure at a wafer level, so that the technology has been expected to be applied to a wide variety of fields such as manufacturing technologies for optical devices such as photonic crystal and biochips such as µ-TATS (Micro Total Analysis System).

In the case where such a processing technology is applied to the semiconductor manufacturing technology, the processing technology is performed in the following manner.

A work (workpiece) including a substrate (e.g., a semiconductor wafer) and a photocurable resin material layer disposed on the substrate and a mold on which a desired imprint (projection/recess) pattern is formed are disposed opposite to each other and between the work and the mold, the resin material is filled, followed by irradiation of ultraviolet (UV) light to cure the resin material,

By this, the above pattern is transferred onto the resin material layer and then etching on the like is effected by using the resin material layer as a mask, so that pattern formation on the substrate is performed.

In the case where the (nano-)imprint is used as lithography for the semiconductor manufacturing technology, a step-and-repeat method in which a transfer onto a substrate repeatedly performed by using a mold smaller in size than the substrate is suitable (T. Bailey et al., J. Vac. Sci. Technol. B, Vol. 18, No. 6, pp. 3572 - 3577 (2000)). This is because it is possible to improve accuracy by reducing an integral error of alignment and the mold pattern itself due to an increase in wafer size and it is possible to reduce a production cost of the mold increased by the increase in wafer size.

However, the above-described imprint method involves a problem such that it is difficult to produce a device in a size larger than that of the mold.

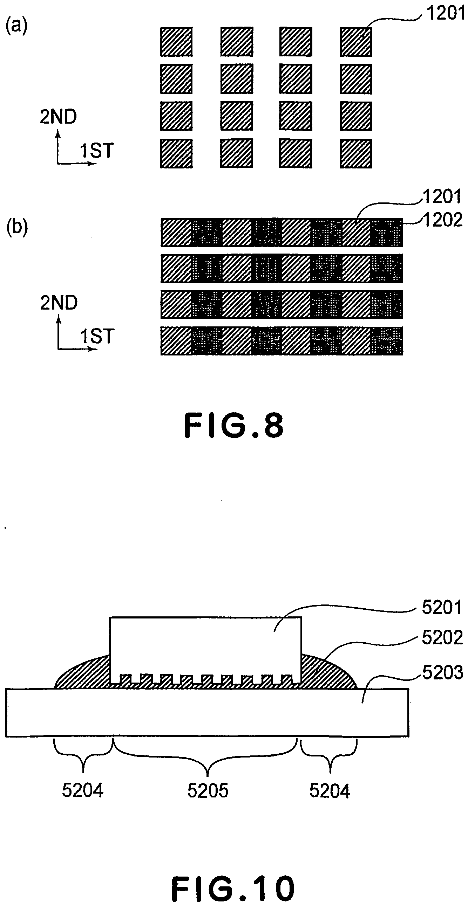

That is, as shown in Figure 10, when imprint for one shot is performed in the case where the pattern is formed on a substrate 5203 by processing the substrate 5203, a resin material 5202 can be pushed out of a shot area to form an outside area 5204 along an edge of a mold 5201. The thus formed outside area 5204 has a width which is generally larger than a size of the pattern or a period of the pattern. Further, the thickness of the resin material layer in the outside area 5204 is larger than that in the shot area (processed area) 5205 in many cases. For example, the thickness of the resin material layer and an unevenness of the pattern in the processed area 5205 is about several tens of nm to about several hundreds of nm, whereas the thickness of the resin material layer in the outside area 5204 can be several µm or more.

In such an outside area 5204, it is difficult to form the pattern and therefore a gap corresponding to at least the width of the outside area 5204 is created between adjacent shot areas. As a result, it is difficult to produce a large-size device by connecting patterns transferred from the pattern of the mold. Further, even in the case where the large-size device is not produced, there arises such a problem that the number of chips prepared from one wafer is decreased by the presence of the outside area 5204 to increase the production cost.

Document EP-A-1 762 893 discloses a mold, an imprint apparatus, and a process for producing a structure. In order to alleviate or suppress curing of a photocurable resin material in an area in which the curing of the photocurable resin material is not intended, exposure of the photocurable resin material to light is suppressed through a non-pattern portion at which a light-blocking member is provided by means of a mold having an imprint pattern portion and the non-pattern portion or is suppressed by disposing a light-blocking member so as not to irradiate the photocurable resin material with light not via the mold.

Document US-A-2004 008334 discloses step and repeat imprint lithography systems. Specifically, described are systems for patterning a substrate by imprint lithography. Imprint lithography systems include an imprint head configured to hold a template in a spaced relation to a substrate. The imprint lithography system is configured to dispense an activating light curable liquid onto a substrate or template. The system includes a light source that applies activating light to cure the activating light curable liquid.

### DISCLOSURE OF THE INVENTION

In view of the above-described problem, a principal object of the present invention is to provide an imprint method capable of connecting patterns of adjacent processed areas to each other to reduce the production cost.

Another object of the present invention is to provide a method of processing a substrate using the imprint method.

According to the present invention, it is possible to realize an imprint method capable of connecting patterns of adjacent processed areas to each other to reduce the production cost. It is also possible to realize a substrate processing method using the imprint method.

This object is achieved by an imprint method according to claim 1. Advantageous further developments are as set forth in the dependent claims. Furthermore, a processing method according to claim 6 and a structure procuded by the processing method are defined.

These and other objects, features, and advantages of the present invention will become more apparent upon a consideration of the following description of the preferred embodiments of the present invention taken in conjunction with the accompanying drawings.

### [BRIEF DESCRIPTION OF THE DRAWINGS]

Figure 1 is a flow chart of an imprint method in Embodiment 1 of the present invention.
Figures 2(a) to 2(e) are schematic views for illustrating a removal step of a resin material in an outside area in Embodiment 1 of the present invention.
Figures 3(a) to 3(c) are schematic views for illustrating a pattern forming step for a second time using a mold having a structure for blocking light emitted to a part of the resin material extruded into a periphery of a processed area in Embodiment 1 of the present invention.
Figures 4(a) to 4(c) are schematic views for illustrating an arrangement of processed areas in respective transfer steps in an imprint method for repeating a pattern forming step in Embodiment 1 of the present invention.
Figures 5(a) to 5(c) are schematic views for illustrating a transfer method of a pattern onto a substrate in Embodiment 1 of the present invention.
Figures 6(a) and 6(b) are schematic views for illustrating connection of the pattern in Embodiment 1 of the present invention.
Figures 7 (a) to 7 (d) and Figures 8 (a) and 8 (b) are schematic views for illustrating arrangements of processed areas in Embodiment 2 of the present invention.
Figures 9(a) to 9(d) are schematic views for illustrating substrate processing in Embodiment 2 of the present invention.
Figure 10 is a schematic view for illustrating a problem of a conventional substrate processing method using imprint.

### [BEST MODE FOR CARRYING OUT THE INVENTION]

Embodiments of the present invention will be described.

In the embodiments of the imprint method according to the present invention, when a pattern of a mold is imprinted, a pattern forming step in which a processed area is formed and a resin material in an outside area is removed is repeated multiple times. In second or subsequent transfer steps, a part of the resin material extruded from the processed area into the outside area at a periphery of the processed area formed in a first transfer step is removed from the outside area and subsequent pattern transfer is performed in a processed area which overlaps with the outside area.

When a plurality of processed areas is formed in the above-described processed area with respect to at least one of a first direction and a second direction perpendicular to the first direction by imprint performed multiple times in the first transfer step, an interval between adjacent processed areas of the plurality of processed areas is an integral multiple of a length of a width of each processed area. By this, it is possible to realize an imprint method capable of easily transferring a pattern onto a resin material not only in the processed area but also in the outside area into which the resin material is extruded from the processed area to eliminate or decrease an interval between adjacent shot areas (adjacent processed areas), thus being capable of connecting patterns in the adjacent shot areas to each other.

Further, in the embodiments of the processing method according to the present invention, in succession to the removal step of the resin material in the outside area in the above-described imprint method, it is possible to perform processing of the substrate by using the pattern formed on the resin material on the substrate through the transfer of the pattern of the mold. Herein, the substrate means a member to be processed including not only a single substrate such as a silicon wafer but also a multi-layer substrate on which multiple films are formed.

Hereinbelow, embodiments of the present invention will be described with reference to the drawings. In the respective figures, identical or corresponding portions are represented by identical reference numerals or symbols.

### (Embodiment 1)

In Embodiment 1, an imprint method according to the present invention will be described.

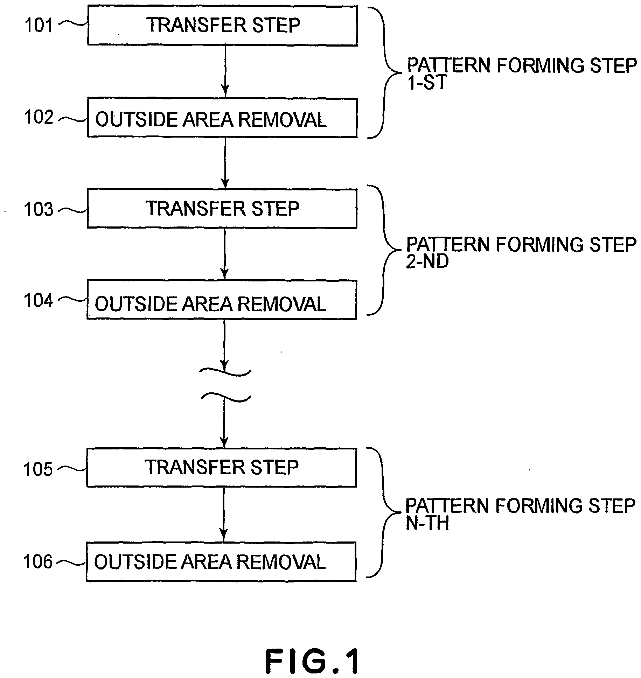

Figure 1 is a flow chart of the imprint method in this embodiment.

A step 101 is a first transfer step in which imprint for transferring a pattern of a mold onto a resin material layer formed on a substrate is performed once or plural times by the step-and-repeat method to form a first processed area.

A step 102 is a first removal step in which the resin material extruded in the step 101 from the first processed area into a peripheral portion in an outside area is removed. By this, a first pattern is formed.

In this way, the pattern forming step in this embodiment is, as described above, consisting of a series of the transfer step and the removal step for removing the resin material layer in the outside area after the transfer step.

A step 103 is a second transfer step for forming a second processed area. In this step, an imprint step is performed so that the second processed area overlaps with the outside area from which the resin material layer is removed in the step 102.

A step 104 is a second removal step in which the resin material extruded from the second processed area into a peripheral portion in an outside area in the step 103 is removed. By this, a second pattern is formed.

In this way, by repeating multiple times the pattern forming step consisting of the series of the transfer step and the removal step also in a third pattern forming step or later, it is possible to transfer the pattern onto the resin material layer even in the once created outside area.

In Figure 1, a step 105 is an N-th transfer step and a step 106 is an N-th removal step.

In an embodiment described later, the case of performing the pattern forming step three times will be described.

Next, imprint steps in this embodiment will be specifically described.

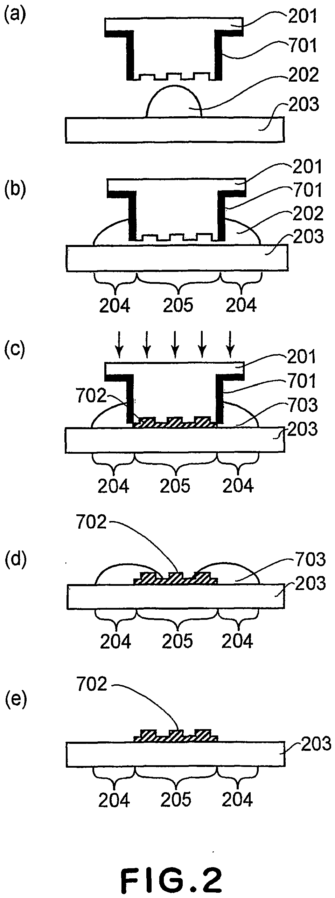

Figures 2(a) to 2(e) are schematic views for illustrating the imprint steps in this embodiment.

First, in a step as shown in Figure 2(a), a resin material layer 202 is formed on a substrate 203. Thereafter, in a step shown in Figure 2(b), a mold 201 and is brought into contact with the resin material layer 202 to fill the resin material between the mold 201 and the substrate 203. At this time, a part of the resin material layer 202 pressed out of a processed area 205 by the mold 201 is formed in an outside area (extrusion area) 204.

The light blocking film 701 is a film for blocking light so that the resin material layer 202 in the outside area 204 is not cured by light irradiation and is provided to the mold 201 at a position where the pattern of the mold 201 is not formed. The resin material layer 202 is formed of a photocurable resin material. Next, in a step shown in Figure 2(c), the resin material layer 202 is cured by irradiation with ultraviolet (UV) rays or the like from a back surface side of the mold 201. The mold 201 is provided with the light blocking film 701, so that it is possible to cure only a resin material layer 702 in the processed area 205 and place a resin material layer 703 in the outside area 204 in an uncured state. Then, in a step shown in Figure 2(d), the mold 201 is separated from the resin material layer 702 and the uncured resin material layer 703, so that the pattern on the mold 201 is transferred onto the resin material layer 702.

Then, as shown in Figure 2(e), only the resin material layer 703 in the outside area 204 can be removed by using a solvent such as acetone or the like.

In this embodiment, the mold 201 has a desired pattern at its surface and is formed of a material such as silicon, quartz, or sapphire. The surface where the pattern is formed is generally subjected to parting processing using a fluorine-based silane coupling agent or the like. Herein, the mold having such a parting layer formed by the parting processing is inclusively referred to as the "mold".

As a material for the resin material layer 202, it is possible to employ acrylic or epoxy photocurable resin material, or the like.

As a method of forming the resin material layer 202 on the substrate 203, it is possible to apply an ink jet method, a dropwise application method using a dispenser, a spin coating method, or the like.

The light blocking film 701 may be a film of method such as Cr formed by sputtering, chemical vapor deposition (CVD), vacuum deposition, ion plating. The light blocking film 701 may also be a film which does not completely block light capable of curing the photocurable resin material. In this case, the film may be only required to cause a necessary difference in degree of curing between in an area in which the light is not blocked and in an area in which the light is blocked.

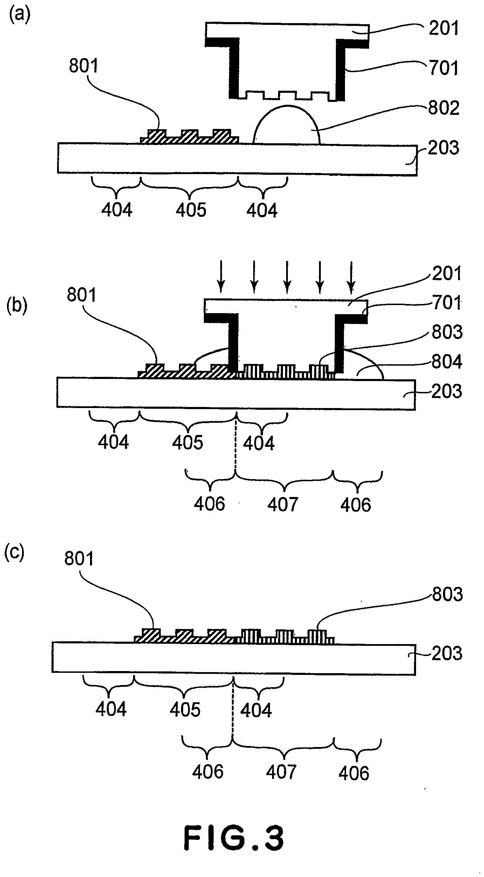

Figures 3(a) to 3(c) are schematic views for illustrating a second pattern forming step when a mold having a structure for blocking light emitted to the resin material extruded into the periphery of the processed area.

In Figure 3(a), a resin material layer 802 for a second transfer step is disposed in an area adjacent to a resin material layer 801 formed in the first transfer step.

At this time, it is necessary to dispose the resin material layer 802 and the mold 201 so that a processed area 407 in an imprint step of a second transfer step overlaps with the outside area 404 in the first transfer step.

In Figure 3 (b), the mold 201 is brought into contact with the resin material layer 802 and a resultant resin material layer 803 is irradiated with light from a back surface side of the mold 201, so that the resin material layer 803 formed in a processed area 407 in the second transfer step is cured. On the other hand, a resin material layer 804 formed in an outside area 406 in the second transfer step by using the light blocking film 701 is not cured. In Figure 3(b), when the mold 201 is brought into contact with the resin material layer 802, a part of the resin material layer 804 in an outside area 406 is also located on the resin material layer 801 in the processed area 405. However, the resin material layer 801 has already been cured in the first pattern forming step, so that the resin material layer 801 is not mixed with the uncured resin material layer 804. As a result, it is possible to remove only the resin material layer in the outside area.

Similarly, also in a third pattern forming step, a pattern is transferred in a state in which a third processed area is superposed on the outside area in the preceding step, and then only the resin material layer in the outside area is removed.

Through the above-described steps, as shown in Figure 3(b), it is possible to form the resin material layer, on the substrate 203, on which a desired pattern is transferred.

As described above, by using a removing method using the mold provided with the light blocking film, it is possible to realize the gap reduction (elimination) between the adjacent processed areas and the connection of patterns in the adjacent processed areas. In this case, it is possible to remove the resin material layer in the outside area only by dissolving the resin material layer in a solvent. For this reason, it is possible to alleviate damage to the substrate during the resin material layer removal in the outside area.

Next, the imprint method for performing the pattern forming step three times will be described more specifically.

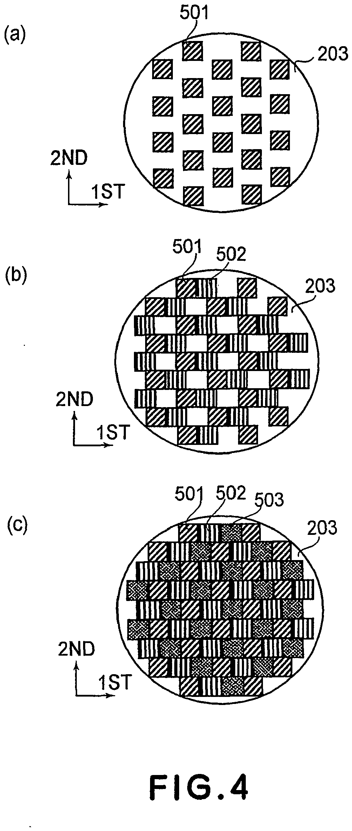

Figures 4(a) to 4 (c) are top views for illustrating arrangement of processed areas in transfer steps in the imprint method for performing the pattern forming step three times. A reference numeral 501 represents a processed area (first processed area) in a first transfer step, a reference numeral 502 represents a processed area (second processed area) in a second transfer step, and a reference numeral 503 represents a processed area (third processed area) in a third transfer step.

Figure 4(a) shows arrangement of the processed area (first processed area) in the first transfer step in a first pattern forming step. With respect to arrangement in a first direction (1ST) in Figure 4(a), an interval between adjacent processed areas with respect to the first direction is an integral multiple of, e.g., two times, a width of the processed area with respect to the first direction. The "two times" the width of the processed area means "two times" the width of the processed area to which an adjusting amount for the sum of a mold processing error and a mold alignment error is added, and in the following description, similar meanings are applied.

With respect to arrangement in a second direction (2ND) perpendicular to the first direction (1ST), each processed area is moved in the first direction by a distance which is one time the processed area width and is moved in the second direction by a distance which is, e.g., 1.5 times the processed area width. The distance of the movement of each processed area in the second direction is not limited to 1.5 times the processed area width but is at least a distance which is the sum of the processed area width and a width of the outside area and at most a distance obtained by subtracting the outside area width from a length which is two times the processed area width.

Figure 4(b) shows arrangement of the processed areas 502 in the second transfer step in a second pattern forming step. With respect to the first direction in Figure 4(b), the processed areas 502 are disposed adjacently to the processed areas 501 arranged in the first transfer step.

Figure 4(c) shows arrangement of the third processed areas 503 in the third transfer step in a third pattern forming step. With respect to the first direction in Figure 4(c), the third processed areas 503 in the third transfer step are disposed between the first processed areas 501 and the second processed areas 502 in the first and second transfer steps.

By arranging the processed areas as in this embodiment, it is possible to transfer a pattern on a substantially entire substrate 203 by repeating the pattern forming step three times.

Also in the case of repeating the pattern forming step three times or more, an interval between adjacent processed areas of the plurality of processed areas is set to a length obtained by multiplying a length of the processed area width by the number of repeated pattern forming steps performed after completion of the first pattern forming step, so that the pattern can be similarly transferred onto the substantially entire substrate. However, generally, in the transfer step and the removal step in the pattern forming step, an apparatus used is required to be exchanged. For this reason, in order to improve throughput of the processing method, the number of repeatedly performed pattern forming steps may preferably be small.

By arranging the processed areas as in this embodiment, it is possible to reduce a gap between adjacent processed areas with respect to all the adjacent processed areas and connect patterns of all the processed areas to each other only through three-time repetition of the pattern forming step.

Figures 4(a) to 4(c) merely illustrates an example of this embodiment. Therefore, the number of imprint steps in each transfer step or the like varies depending on sizes or shapes of the mold and the substrate.

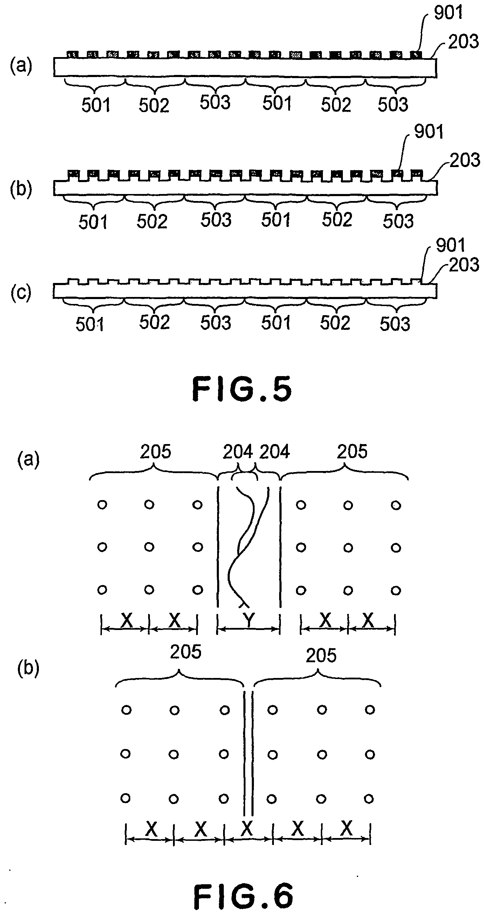

In this embodiment, it is also possible to transfer the pattern onto the substrate 203 through the resin material layer on which the pattern is transferred as the mask. Figures 5(a) to 5(c) are sectional views for illustrating a method therefor.

The resin material layer transferred on the substrate has a portion which is generally called the residual film as a ground work for the pattern.

Figure 5(a) shows a resin material layer 901 after the residual film of the resin material layers 801, 803 and the like is removed. That is, this state is in a stage such that the thickness of the resin material layer on the entire substrate surface is uniformly reduced by etching of the resin material layer until the residual film is eliminated from the state of the resin material layer shown in Figure 4(b). Next, by using the remaining resin material layer 901 as the mask, the substrate is etched to form a state shown in Figure 5(b). Finally, by removing the remaining resin material layer 901, as shown in Figure 5(c), it is possible to transfer a desired pattern onto the substrate.

When a dot pattern with a pitch of X is transferred in the processed area 205, a state of Figure 6(a) can be created in the case where the present invention is not applied. That is, when a width between adjacent processed areas in the outside area 204 is Y, the pitch is Y or more. In the case where Y is larger than X, it is difficult to set the pitch between the adjacent processed areas such as to be X.

On the other hand, in the present invention, as shown in Figure 6(b), the pattern can be formed also in the outside area to bring the adjacent processed areas near to each other, so that the pitch of the dot pattern between the adjacent processed areas can be set to X.

As described above, in this embodiment, it is possible to connect the patterns of the adjacent processed areas to each other. Such a processing method can be suitably used for a structure such as photonic crystal such that a distribution of refractive index is arranged periodically with respect to an in-plane direction.

As the connectable pattern, in addition to the dot pattern, it is also possible to employ other patterns such as a line-and-space pattern, a hole pattern, a free pattern.

Further, in this embodiment, the shape of the mold in the processed area is not limited to a square but may also be various shapes such as a hexagon.

Further, it is also possible to connect the patterns without using the light blocking film. This alternative is however not covered by the claims.

That is, a first protection layer for protecting a first processed area is formed on the first processed area and a resin material layer in an outside area is removed while a pattern formed on a resin material layer in the processed area is protected by the first protection layer so as not to be removed. Next, a mold is brought into contact with a resin material layer formed in an area which includes an outside area and is adjacent to the first processed area to form a second processed area.

Then, on the resin material layer in the second processed area, a second protection layer for protecting the second processed area is formed.

Finally, the resin material extruded from the second processed area into a periphery of the second processed area while the patterns formed on the resin material layers in the first and second processed areas are protected by the first and second protection layers so as not to be removed.

In this way, the resin material is applied onto a substrate and imprint with the mold is performed once or multiple times to form the first processed area, and the resin material extruded into the periphery of the first processed area is removed to form a pattern for a first time. Then, a pattern for a second time may be formed by repeating the same step as in the first pattern forming step in the area which includes the outside area and is adjacent to the first processed area.

### (Embodiment 2)

In Embodiment 2, an arranging method of processed areas different from that in Embodiment 1 will be described.

A difference of this embodiment from Embodiment 1 is an arranging manner of processed areas in each of transfer steps and therefore only the difference will be explained.

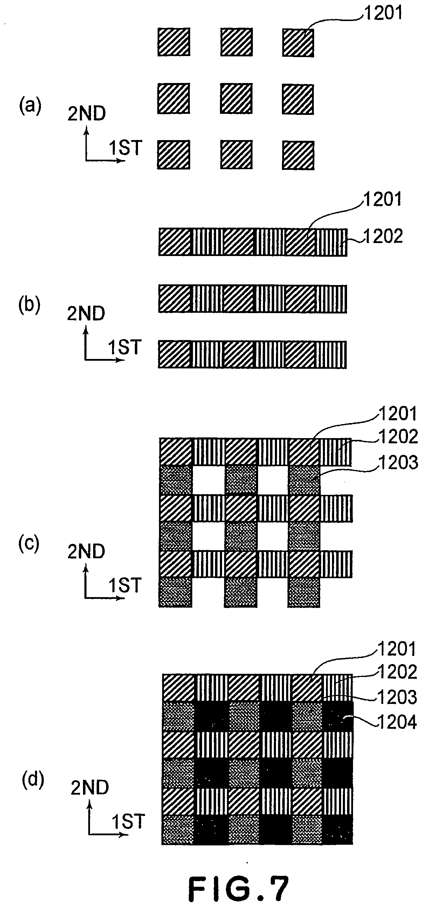

With reference to Figures 7(a) to 7(d), a method of repeating the pattern forming step four times will be described.

A reference numeral 1201 represents a processed area in a first transfer step, a reference numeral 1202 represents a processed area in a second transfer step, a reference numeral 1203 represents a processed area in a third transfer step, and a reference numeral 1204 represents a processed area in a fourth transfer step.

First, as shown in Figure 7(a), in the first transfer step, pattern transfer in the processed area 1201 is performed with an arrangement period, of the processed areas 1201, which is two times the processed area width both with respect to the first direction and the second direction, and thereafter the removal step is performed.

Next, as shown in Figure 7(b) and Figure 7(c), in the second transfer step and the third transfer step, a pattern is transferred in the processed area 1202 between horizontal adjacent processed areas 1201 and in the processed area 1203 between vertical adjacent processed areas 1201, respectively, and thereafter the corresponding removal step is performed.

Finally, as shown in Figure 7(d), in the remaining processed area 1204, a pattern is transferred in the fourth transfer step and thereafter the removal step is performed.

In the method in which the pattern forming step is repeated three times, edges of the processed areas cannot be aligned with respect to either one of the first direction and the second direction. On the other hand, in the method in which the pattern forming step is repeated four times, the edges of the processed areas can be aligned with respect to both of the first direction and the second direction.

That is, even in the case where it is necessary to align the edges of the processed areas with respect to both of the first direction and the second direction, e.g., in the case of dicing the substrate along the edges of the processed areas in a mesh-like shape.

A method of repeating the pattern forming step two times will be described with reference to Figures 8 (a) and 8(b).

As shown in Figure 8(a), in a first transfer step, pattern transfer in a processed area 1201 is performed with an arrangement period, of the processed areas 1201, which is two times the processed area width with respect to the first direction and with an appropriate interval between adjacent processed areas with respect to the second direction and thereafter the removal step is performed. The appropriate interval is such that the outside area in each outside area does not overlap with an adjacent processed area.

Next, as shown in Figure 8(b), in a second transfer step, a pattern is transferred in the processed areas 1202 between adjacent processed areas 1201 with respect to the first direction in the first transfer step and thereafter the removal step is performed.

Through the above-described steps, in the case where it is necessary to connect transfer patterns of the respective processed areas to each other only with respect to one direction, it is possible to transfer the pattern repeating the pattern forming step only two times smaller than three times.

In the present invention, the number of repetition of the pattern forming step, the arranging method of the processed areas, the order of the arrangement, and the shape of the mold in the processed area are not limited to those described above.

### (Embodiment 3)

In Embodiment 3, an arranging method of processed areas different from those of Embodiments 1 and 2 will be described.

A difference of Embodiment 3 from Embodiments 1 and 2 is a constitution of the mold used in each of the transfer steps and therefore only the difference will be described.

In the present invention, the same mold is not necessarily used in the respective transfer steps. That is, e.g., in the method of repeating the pattern forming step four times in Embodiment 2, it is also possible to use different molds in the first to fourth transfer steps, respectively.

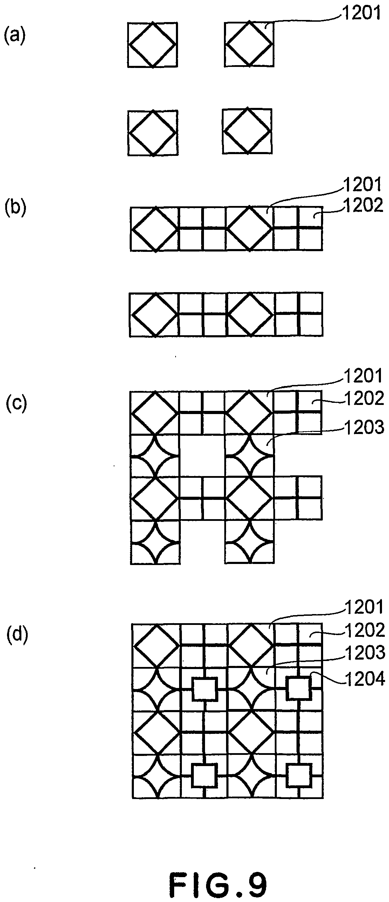

Figure 9(a) shows a stage after the first transfer step is completed.

Figure 9(b) shows a stage after the second transfer step is completed. The mold used in the second transfer step has a pattern different from that of the mold used in the first transfer step.

Figure 9(c) shows a stage after the third transfer step is completed. The mold used in the third transfer step has a pattern different from those of the molds used in the first and second transfer steps.

Figure 9(d) shows a stage after the fourth transfer step is completed. The mold used in the fourth transfer step has a pattern different from those of the molds used in the first to third transfer steps.

When the mold having the same pattern is used in all the transfer steps, only a pattern with a period corresponding to one processed area at the largest can be transferred. However, as in this embodiment, the molds having the different patterns are used in the transfer steps, respectively, so that it is possible to transfer a pattern having a four-time periodical structure.

As described above, in this embodiment, the mold having the different pattern is used in each of the respective transfer steps, so that it is possible to transfer a pattern with a larger period.

### [INDUSTRIAL APPLICABILITY]

According to the present invention, it is possible to provide an imprint method capable of connecting patterns of adjacent processed areas to each other to reduce a production cost. It is also possible to provide a processing method of a substrate using the imprint method.

While the invention has been described with reference to the structures disclosed herein, it is not confined to the details set forth and this application is intended to cover such modifications or changes as may come within the purpose of the improvements or the scope of the following claims.

## Claims

1. An imprint method in which a step of forming a pattern by imprinting a pattern of a mold (201) onto a resin material (202; 802) on a substrate (203) is repeated multiple times, said imprint method comprising:
a step of preparing the mold (201) including a light blocking member (701) at a position in which the pattern is not formed;
a step (101) of forming a pattern for a first time through steps including a step of bringing the mold (201) into contact with a photocurable resin material (202) provided on the substrate (203), a step of forming a first processed area (205; 405; 501; 1201) by curing the photocurable resin material (202) through light irradiation, and a step (102) of removing a part (703) of the photocurable resin material (202) extruded from the first processed area (205; 405; 501; 1201) into an outside area (204) at a periphery of the first processed area (205; 405; 501; 1201): and
a step (103) of forming a pattern for a second time through steps including a step of bringing the mold (201) into contact with a photocurable resin material (802) provided on the substrate (203) in an area (407) which includes the outside area (204) and is adjacent to the first processed area (205; 405; 501; 1201), a step of forming a second processed area (407; 502; 1202) by curing the photocurable resin material (802) in the area, and a step of removing a part (804) of the photocurable resin material (802) extruded from the second processed area (407; 502; 1202) at a periphery of the second processed area (407; 502; 1202).

2. A method according to claim 1, wherein in said step (101) of forming the pattern for the first time, when a plurality of processed areas (501; 1201) is formed in the first processed area with respect to at least one of a first direction and a second direction perpendicular to the first direction, an interval between adjacent processed areas of the plurality of the processed areas (501; 1201) is an integral multiple of a length of a width of each processed area.

3. A method according to claim 2, wherein the length of the width of each processed area (501; 1201) includes a length corresponding to an adjusting amount including a processing error of the mold (201) and an alignment error between the substrate (203) and mold (201).

4. A method according to claim 2, wherein said step (101) of forming the pattern is repeated three times, and
wherein said imprint method further comprises:
a step of forming each of the processed areas (501, 502, 503) so that an interval between adjacent processed areas of the plurality of processed areas formed in the first processed area (501) with respect to the first direction is two times a length of a width of the first processed area and an interval between adjacent processed areas of the plurality of processed areas formed in the first processed area (501) with respect to the second direction is one time a length of a width of the first processed area; and
a step of forming a third processed area (503) in an area adjacent to the second processed area (502) after said step of forming the pattern for the second time.

5. A method according to claim 1, wherein when the step of forming the pattern is repeated multiple times, different molds are used in said steps of forming the patterns, respectively.

6. A processing method for processing a substrate (203), comprising:
a step of performing an imprint method according to claim 1 to form a pattern on a resin material on the substrate (203), and
a step of processing the substrate by using said pattern as a mask.

7. A structure produced by using a processing method of a substrate according to claim 6.

## Patentansprüche

1. Prägeverfahren, in dem ein Schritt zum Bilden eines Musters durch Einprägen eines Musters eines Stempels (201) auf ein Harzmaterial (202; 802) auf einem Substrat (203) mehrere Male wiederholt wird, wobei das Prägeverfahren umfasst:
einen Schritt zum Vorbereiten des Stempels (201), der ein Lichtblockierelement (701) bei einer Position umfasst, bei der das Muster nicht gebildet wird,
einen Schritt (101) zum Bilden eines Musters für ein erstes Mal durch Schritte, die einen Schritt zum Inkontaktbringen des Stempels (201) mit einem lichthärtbaren Harzmaterial (202), das auf dem Substrat (203) bereitgestellt ist, einen Schritt zum Bilden eines ersten bearbeiteten Bereichs (205; 405; 501; 1201), indem das lichthärtbare Harzmaterial (202) durch Lichtbestrahlung ausgehärtet wird, und einen Schritt (102) zum Entfernen eines Teils (703) des lichthärtbaren Harzmaterials (202) umfasst, der von dem ersten bearbeiteten Bereich (205; 405; 501; 1201) in einen außen liegenden Bereich (204) bei einer Peripherie des ersten bearbeiteten Bereichs (205; 405; 501; 1201) herausgedrückt wird, und
einen Schritt (103) zum Bilden eines Musters für ein zweites Mal durch Schritte, die einen Schritt zum Inkontaktbringen des Stempels (201) mit einem lichthärtbaren Harzmaterial (802), das auf dem Substrat (203) in einem Bereich (407) bereitgestellt ist, der den außen liegenden Bereich (204) umfasst und zu dem ersten bearbeiteten Bereich (205; 405; 501; 1201) benachbart ist, einen Schritt zum Bilden eines zweiten bearbeiteten Bereichs (407; 502; 1202), indem das lichthärtbare Harzmaterial (802) in dem Bereich ausgehärtet wird, und einen Schritt zum Entfernen eines Teils (804) des lichthärtbaren Harzmaterials (802) umfasst, der von dem zweiten bearbeiteten Bereich (407; 502; 1202) bei einer Peripherie des zweiten bearbeiteten Bereichs (407; 502; 1202) herausgedrückt wird.

2. Verfahren nach Anspruch 1, wobei in dem Schritt (101) zum Bilden des Musters für das erste Mal, wenn eine Vielzahl von bearbeiteten Bereichen (501; 1201) in dem ersten bearbeiteten Bereich in Bezug auf zumindest eine einer ersten Richtung und/oder einer zweiten Richtung, die senkrecht zu der ersten Richtung ist, gebildet wird, ein Intervall zwischen benachbarten bearbeiteten Bereichen der Vielzahl der bearbeiteten Bereiche (501; 1201) ein ganzzahliges Vielfaches einer Länge einer Breite jedes bearbeiteten Bereichs ist.

3. Verfahren nach Anspruch 2, wobei die Länge der Breite jedes bearbeiteten Bereichs (501; 1201) eine Länge umfasst, die einer Einstellgröße entspricht, die einen Verarbeitungsfehler des Stempels (201) und einen Ausrichtungsfehler zwischen dem Substrat (203) und dem Stempel (201) umfasst.

4. Verfahren nach Anspruch 2, wobei der Schritt (101) zum Bilden des Musters drei Mal wiederholt wird, und
wobei das Prägeverfahren ferner umfasst:
einen Schritt zum Bilden jedes der bearbeiteten Bereiche (501, 502, 503), so dass ein Intervall zwischen benachbarten bearbeiteten Bereichen der Vielzahl von bearbeiteten Bereichen, die in Bezug auf die erste Richtung in dem ersten bearbeiteten Bereich (501) gebildet werden, zwei Mal eine Länge einer Breite des ersten bearbeiteten Bereichs ist, und ein Intervall zwischen benachbarten bearbeiteten Bereichen der Vielzahl von bearbeiteten Bereichen, die in Bezug auf die zweite Richtung in dem ersten bearbeiteten Bereich (501) gebildet wird, ein Mal eine Länge einer Breite des ersten bearbeiteten Bereichs ist, und
einen Schritt zum Bilden eines dritten bearbeiteten Bereichs (503) in einem Bereich, der benachbart zu dem zweiten bearbeiteten Bereich (502) ist, nach dem Schritt zum Bilden des Musters für das zweite Mal.

5. Verfahren nach Anspruch 1, wobei, wenn der Schritt zum Bilden des Musters mehrere Male wiederholt wird, jeweils unterschiedliche Stempel in den Schritten zum Bilden der Muster verwendet werden.

6. Verarbeitungsverfahren zum Verarbeiten eines Substrats (203), mit:
einem Schritt zum Ausführen eines Prägeverfahrens nach Anspruch 1, um ein Muster auf einem Harzmaterial auf dem Substrat (203) zu bilden, und
einen Schritt zum Verarbeiten des Substrats unter Verwendung des Musters als eine Maske.

7. Struktur, die unter Verwendung eines Verarbeitungsverfahrens eines Substrats nach Anspruch 6 hergestellt ist.

## Revendications

1. Procédé d'impression, dans lequel une étape de formation d'un motif par impression d'un motif d'un moule (201) sur un matériau en résine (202 ; 802) sur un substrat (203) est répétée de multiples fois, ledit procédé d'impression comprenant :
une étape de préparation du moule (201) comprenant un élément de blocage de lumière (701) en une position dans laquelle le motif n'est pas formé ;
une étape (101) de formation d'un motif pour une première fois à l'aide d'étapes comprenant une étape consistant à amener le moule (201) en contact avec un matériau en résine photodurcissable (202) disposé sur le substrat (203), une étape de formation d'une première zone traitée (205 ; 405 ; 501 ; 1201) par durcissement du matériau en résine photodurcissable (202) par irradiation de lumière, et une étape (102) de retrait d'une partie (703) du matériau en résine photodurcissable (202) extrudé à partir de la première zone traitée (205 ; 405 ; 501 ; 1201) dans une zone extérieure (204) à une périphérie de la première zone traitée (205 ; 405 ; 501 ; 1201) ; et
une étape (103) de formation d'un motif pour une deuxième fois à l'aide d'étapes comprenant une étape consistant à amener le moule (201) en contact avec un matériau en résine photodurcissable (802) disposé sur le substrat (203) dans une zone (407) qui comprend la zone extérieure (204) et qui est adjacente à la première zone traitée (205 ; 405 ; 501 ; 1201), une étape de formation d'une deuxième zone traitée (407 ; 502 ; 1202) par durcissement du matériau en résine photodurcissable (802) dans la zone, et une étape de retrait d'une partie (804) du matériau en résine photodurcissable (802) extrudé à partir de la deuxième zone traitée (407 ; 502 ; 1202) à une périphérie de la deuxième zone traitée (407 ; 502 ; 1202).

2. Procédé selon la revendication 1, dans lequel, dans ladite étape (101) de formation du motif pour la première fois, lorsqu'une pluralité de zones traitées (501 ; 1201) sont formées dans la première zone traitée vis-à-vis d'au moins l'une d'une première direction et d'une deuxième direction perpendiculaire à la première direction, un intervalle entre des zones traitées adjacentes de la pluralité de zones traitées (501 ; 1201) est un multiple entier d'une longueur d'une largeur de chaque zone traitée.

3. Procédé selon la revendication 2, dans lequel la longueur de la largeur de chaque zone traitée (501 ; 1201) comprend une longueur correspondant à une valeur d'ajustement comprenant une erreur de traitement du moule (201) et une erreur d'alignement entre le substrat (203) et le moule (201).

4. Procédé selon la revendication 2, dans lequel ladite étape (101) de formation du motif est répétée trois fois, et
ledit procédé d'impression comprenant de plus :
une étape de formation de chacune des zones traitées (501, 502, 503) de telle sorte qu'un intervalle entre des zones traitées adjacentes de la pluralité de zones traitées formées dans la première zone traitée (501) vis-à-vis de la première direction, a deux fois la longueur d'une largeur de la première zone traitée et qu'un intervalle entre des zones traitées adjacentes de la pluralité de zones traitées formées dans la première zone traitée (501) vis-à-vis de la deuxième direction, a une fois la longueur d'une largeur de la première zone traitée ; et
une étape de formation d'une troisième zone traitée (503) dans une zone adjacente à la deuxième zone traitée (502) après ladite étape de formation du motif pour la deuxième fois.

5. Procédé selon la revendication 1, dans lequel, lorsque l'étape de formation du motif est répétée de multiples fois, des moules différents sont utilisés dans lesdites étapes de formation des motifs, respectivement.

6. Procédé de traitement pour traiter un substrat (203), comprenant :
une étape de réalisation d'un procédé d'impression selon la revendication 1 pour former un motif sur un matériau en résine sur le substrat (203), et
une étape de traitement du substrat par l'utilisation dudit motif comme masque.

7. Structure produite par l'utilisation d'un procédé de traitement d'un substrat selon la revendication 6.
